Europäisches Patentamt

European Patent Office

Office européen des brevets

(19)

(11) **EP 0 970 385 B1**

(12) **EUROPÄISCHE PATENTSCHRIFT**

(45) Veröffentlichungstag und Bekanntmachung des Hinweises auf die Patenterteilung:
**12.06.2002 Patentblatt 2002/24**

(21) Anmeldenummer: **98924010.6**

(22) Anmeldetag: **16.03.1998**

(51) Int Cl.7: **G01R 21/133**

(86) Internationale Anmeldenummer:
**PCT/DE98/00772**

(87) Internationale Veröffentlichungsnummer:
**WO 98/44355 (08.10.1998 Gazette 1998/40)**

(54) **ELEKTRIZITÄTSZÄHLER**

ELECTRICITY METER

COMPTEUR ELECTRIQUE

(84) Benannte Vertragsstaaten:
**CH DE FI FR GB LI SE**

(30) Priorität: **27.03.1997 DE 19713120**

(43) Veröffentlichungstag der Anmeldung:
**12.01.2000 Patentblatt 2000/02**

(73) Patentinhaber: **SIEMENS AKTIENGESELLSCHAFT**
**80333 München (DE)**

(72) Erfinder: **WINDSHEIMER, Klaus**
**D-91174 Spalt (DE)**

(56) Entgegenhaltungen:
**EP-A- 0 420 545        DE-C- 740 487**
**DE-C- 19 526 723**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung bezieht sich auf einen Elektrizitätszähler mit auf eine digitale Signalverarbeitungseinrichtung geführten Signalkanälen, von denen jeder einen Analog/Digital-Wandler aufweist, wobei auf einen ersten Eingang des Analog/Digital-Wandlers eines ersten Signalkanals Spannungssignale und auf einen ersten Eingang des Analog/Digital-Wandlers des zweiten Signalkanals Stromsignale eines elektrischen Verbrauchers aufschaltbar sind. Unter Stromsignale werden hier auch zu den jeweiligen Strömen proportionale Spannungssignale verstanden.

Ein derartiger Elektrizitätszähler ist z.B. aus der DE 195 26 723 C1 bekannt. Bei diesem für eine weitgehende Selbstüberwachung seiner Meß- oder Signalkanäle ausgelegten Elektrizitätszähler werden die den jeweiligen unterschiedlichen Signalkanälen zugeordneten Signale zur Bildung von Vergleichswerten verwendet. Dadurch ist eine Plausibilitätskontrolle der erfaßten Meßwerte oder Signale möglich. Auf diese Weise kann beispielsweise festgestellt werden, ob ein interner oder externer Fehler vorliegt, wobei durch logische Verknüpfung in der digitalen Signalverarbeitungseinrichtung gegebenenfalls eine nähere Eingrenzung oder Lokalisierung des Fehlers möglich ist.

Aus der DE-PS 740 487 ist ein Drehstromzähler bekannt, der durch Verwendung der Aronschaltung für einen Drei- und Vierleiteranschluß verwendbar ist.

Der Erfindung liegt die Aufgabe zugrunde, einen solchen Elektrizitätszähler derart weiterzubilden, daß dieser bei gleichzeitig einfachem Schaltungsaufbau sowohl als Vierleiterzähler als auch als Dreileiterzähler einsetzbar ist.

Ausgehend von einem Elektrizitätszähler der eingangs genannten Art wird diese Aufgabe erfindungsgemäß gelöst durch die kennzeichnenden Merkmale des Anspruchs 1. Ein besonders geeignetes Verfahren züm Betreiben des Elektrizitäts zählers ist Gegenstand des Anspruchs 10.

Die Erfindung geht dabei von der Überlegung aus, daß der Elektrizitätszähler, d.h. die diesem zugrunde liegende Schaltung, sowohl für den Betrieb als Dreileiterzähler als auch für den Betrieb als Vierleiterzähler eingesetzt werden kann, wenn schaltungstechnisch die sogenannte Aronschaltung realisiert ist. Dies wiederum kann in einfacher Weise erreicht werden, wenn im die Spannungssignale erfassenden Signalkanal direkt Differenzspannungen erfaßt werden können. Durch geeignete Parametrierung kann dann festgelegt werden, ob ein Betrieb als Vierleiterzähler mit angeschlossenem Nulleiter oder ein Betrieb als Dreileiterzähler mit nicht angeschlossenem Nulleiter vorgesehen ist. Bei Dreileiterbetrieb bildet sich dann ein künstlicher Sternpunkt.

Während beim Betrieb als Vierleiterzähler mit angeschlossenem Nulleiter die Spannungssignale aller drei Phasen (R,S,T) erfaßt werden, werden beim Betrieb als Dreileiterzähler die Differenzspannungen zwischen den Phasen R und S bzw. T und S direkt erfaßt. Dazu weist der Analog/Digital-Wandler im Signalkanal für die Spannungswerte (Spannungskanal) einen zweiten Eingang auf, dem für den Betrieb als Dreileiterzähler das Spannungssignal zweckmäßigerweise der Phase S aufschaltbar ist. Für den Betrieb als Vierleiterzähler wird diesem Eingang ein Nulleiterpotential als Eingangssignal aufgeschaltet.

Als Umschalter für die einzelnen Spannungs- und Stromsignale sind vorzugsweise Multiplexer vorgesehen Mittels dieser Multiplexer ist zweckmäßigerweise sowohl beiden Eingängen des Analog/Digital-Wandlers des Spannungskanals als auch dem ersten Eingang des Analog/Digital-Wandlers des zweiten Signalkanals (Stromkanal) ein Nulleitersignal zuführbar.

Der dem zweiten Eingang des Analog/Digital-Wandlers des Spannungskanals zugeordnete Umschalter oder Multiplexer ist für die Erfassung einer Phase und des Nulleitersignals ausgebildet. Demgegenüber ist die Anzahl der Eingänge des dem jeweils ersten Eingang des Analog/Digital-Wandlers des jeweiligen Signalkanals zugeordneten Multiplexers für die Erfassung von dreiphasigen Meßwerten ausgelegt. Dabei sind die den Analog/Digital-Wandlern vorgeschalteten Multiplexer zweckmäßigerweise miteinander synchronisiert. Dadurch ist ein Vergleich von zeitgleichen Meßwerten oder Signalen möglich. Dies gilt insbesondere für die Bildung von Leistungswerten bei einer Verbrauchsmessung.

Jeder Analog/Digital-Wandler ist zweckmäßigerweise ein Sigma-Delta-Modulator, vorzugsweise zweiter Ordnung. Dabei ist in vorteilhafter Ausgestaltung jedem Analog/Digital-Wandler ein Dezimationsfilter nachgeschaltet. Dieser wandelt einen vom Analog/Digital-Wandler abgegebenen Bitstrom mit hoher Abtastrate in ein für die weitere Signalverarbeitung verfügbares digitales Signal mit vergleichsweise niedriger Abtastrate, jedoch hoher Auflösung um.

Während bezüglich des Spannungskanals eine Hochpaßfilterung mit veränderbarer Zeitkonstante zweckmäßigerweise innerhalb der digitalen Signalverarbeitungseinrichtung erfolgt, ist zweckmäßigerweise für eine Ausfilterung von Gleichstromanteilen ein separates Hochpaß-Filter vorgesehen. Dieses ist innerhalb des Stromkanals der Signalverarbeitungseinrichtung vorgeschaltet.

Der Systemtakt sowohl für die Signalverarbeitungseinrichtung als auch für die Analog/Digital-Wandler wird zweckmäßigerweise von einer separaten Systemtaktvorrichtung erzeugt. Diese ist zweckmäßigerweise eine Teiler, der das Taktsignal einer externen Taktquelle in einem bestimmten Verhältnis herunterteilt.

Die mit der Erfindung erzielten Vorteile bestehen insbesondere darin, daß durch die schaltungstechnische Realisierung einer direkten Messung von Differenzspannungen zwischen den Phasen eines dreiphasigen Drehstromnetzes mit angeschlossenem Nulleiter ohne zusätzliche Hardwarekomponenten und ohne Schaltungsvariation der Betrieb sowohl als Vierleiterzähler als auch als Dreileiterzähler möglich ist. Mit anderen Worten: beide Betriebsarten sind mit derselben Schaltung realisierbar. Die Erfassung der Differenzspannungen erfolgt ohne zusätzlichen Rechenaufwand in einfacher Weise durch Realisierung der Aronschaltung an den Eingängen des Analog/Digital-Wandlers des Spannungskanals. Somit kann die Erfassung der jeweiligen Stromsignale für eine Leistungsmessung zeitgleich mit der Erfassung der Spannungssignale erfolgen.

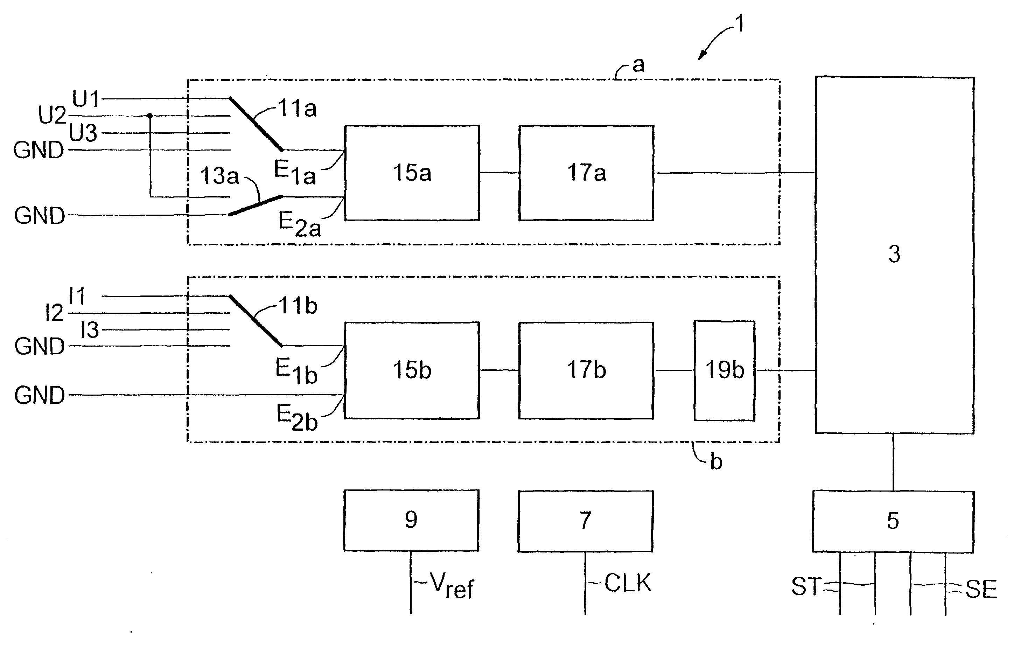

Ein Ausführungsbeispiel der Erfindung wird anhand einer Zeichnung näher erläutert. Darin zeigt die Figur ein Blockschaltbild eines Elektrizitätszählers. Dabei sind gleiche Teile mit gleichen Bezugszeichen versehen, wobei gleiche Details unterschiedlicher Gruppen durch zusätzliche Buchstaben - entsprechend dem jeweiligen Signalkanal a,b - voneinander unterschieden werden.

Die Figur zeigt ein Blockschaltbild eines Elektrizitätszählers (Zähler) 1 mit zwei Signalkanälen a und b, die auf eine gemeinsame digitale Signalverarbeitungseinrichtung 3 geführt sind. In der digitalen Signalverarbeitungseinrichtung 3 erfolgt eine Meßwertverarbeitung zur Verbrauchsmessung sowie für weitere Funktionen des Zählers 1. Die digitale Signalverarbeitungseinrichtung 3 ist vorzugsweise als digitaler Signalprozessor ausgebildet. Alternativ kann sie auch als Recheneinrichtung mit einem Mikrocomputer oder als fest verdrahtete Logikschaltung ausgeführt sein. Wesentlich ist dabei, daß eine digitale Signalbearbeitung der von den Signalkanälen a und b bereitgestellten Signale oder Daten möglich ist. Vorzugsweise sind alle dargestellten Komponenten des Zählers 1 auf einer gemeinsamen Schaltungsplatine zusammengefaßt.

Der digitalen Signalverarbeitungseinrichtung 3 ist eine Schnittstelle 5 zugeordnet, über die Steuersignale ST von außen zugeführt und Ergebnissignale SE, z.B. eine Wirkund/oder Scheinleistung, ausgekoppelt werden können. Weiter dargestellt ist eine Systemtaktvorrichtung 7, der ein Taktsignal CLK zuführbar ist. Ferner ist eine Einrichtung 9 zur Aufbereitung einer von außen zuführbaren Referenzspannung $V_{ref}$ dargestellt. Alle in der Figur gezeigten Komponenten des Zählers 1 können in einem IC oder einem ASIC realisiert sein.

Der erste Signalkanal a ist als Spannungskanal und der zweite Signalkanal b ist als Stromkanal ausgebildet. Vorliegend wird davon ausgegangen, daß dreiphasige Signale inklusive eines Nulleitersignals von einem entsprechenden Verbraucher oder Netz verarbeitet werden. Dem ersten Signalkanal a sind daher die Spannungssignale U1 bis U3 und ein Nulleitersignal GND zugeführt. Der zweite Signalkanal b erhält die Stromsignale I1 bis I3 der jeweiligen Phase sowie ebenfalls das Nulleitersignal GND.

Die oben genannten Signale sind jeweils auf nicht näher bezeichnete Eingänge von Multiplexern 11a, 11b des jeweiligen Signalkanals a bzw. b geführt.

Der erste Signalkanal a enthält außerdem als Umschalter einen weiteren Multiplexer 13a, auf dessen Eingänge das Spannungssignal U2 und das Nulleitersignal GND geführt sind. Die parallele Aufschaltung von Signalen auf mehrere Multiplexer 11a,11b,13a, insbesondere die Aufschaltung des Spannungssignals U2 und des zusätzlichen Nulleitersignals GND, kann durch eine interne Verschaltung im Zähler 1, z.B. durch eine entsprechende Verdrahtung auf einer Leiterplatte, realisiert sein. Auch ist eine externe Verdrahtung möglich.

Im ersten Signalkanal a sind den Multiplexern 11a und 13a ein Analog/Digital-Wandler in Form eines Sigma-Delta-Modulators 15a nachgeschaltet. Dabei ist der Multiplexer 11a ausgangsseitig mit einem ersten, positiven Eingang $E_{1a}$ des Modulators 15a verbunden, während der weitere Multiplexer 13a ausgangsseitig mit einem zweiten, negativen Eingang $E_{2a}$ des Modulators 15a verbunden ist. Diese beiden Eingänge $E_{1a}$ und $E_{2a}$ bilden gemeinsam einen Differenzeingang. Zwischen den Modulator 15a und die digitale Signalverarbeitungseinrichtung 3 ist ein Dezimationsfilter 17a geschaltet, welches das digitale Ausgangssignal des Modulators 15a für die Signalverarbeitungseinrichtung 3 aufbereitet.

Analog ist im zweiten Signalkanal b der Multiplexer 11b ausgangsseitig mit einem Analog/Digital-Wandler in Form eines Sigma-Delta-Modulators 15b verbunden. Dazu ist der Multiplexer 11b auf den ersten, positiven Eingang $E_{1b}$ des Modulators 15b geschaltet. Dem zweiten, negativen Eingang $E_{2b}$ wird das Nulleitersignal GND direkt zugeführt.

Ausgangsseitig ist der Modulator 15b wiederum mit einem Dezimationsfilter 17b verbunden. Dieser ist jedoch im Unterschied zum ersten Signalkanal a über ein separates Hochpaß-Filter 19b mit der digitalen Signalverarbeitungseinrichtung 3 verbunden. Dieses Hochpaß-Filter 19b dient zur Ausfilterung von Gleichstromanteilen aus dem vom Dezimationsfilter 17b gelieferten Ausgangssignal. Die Funktionalität eines solchen Hochpaß-Filters ist beim ersten Signalkanal a in der digitalen Signalverarbeitungseinrichtung 3 realisiert, wobei dort eine einstellbare Änderung der Zeitkonstante der Hochpaß-Filterung erfolgt.

Die Multiplexer 11a,11b und 13a sind auf einen gemeinsamen Systemtakt synchronisiert. Dazu liefert die Systemtaktvorrichtung 7, die z.B. ein Teiler in Form eines Zählers ist, ein aus dem Taktsignal CLK abgeleitetes Taktsignal, das in nicht näher dargestellter Art und Weise sowohl den Multiple-xern 11a, 11b und 13a als auch der digitalen Signalverarbeitungseinrichtung 3 zugeführt ist. Eine entsprechende Aufschaltung erfolgt vorzugsweise wiederum durch eine entsprechende Verdrahtung auf einer die dargestellten Komponenten tragenden Leiterplatte. Den Analog/Digital-Wandlern oder Modulatoren 15a und 15b wird außerdem die Referenzspannung $V_{ref}$ als "Bandgap" mit z.B. 1,23 Volt zugeführt. Auch hier erfolgt die (nicht dargestellte) Verdrahtung wiederum vorzugsweise auf der Leiterplatte.

Beim Betrieb als Vierleiterzähler ist der weitere Multiplexer 13a des ersten Signalkanals a auf das auf Nulleiterpotential bezogene Nulleitersignal GND geschaltet. Dem zweiten Eingang $E_{2a}$ des Modulators 15a wird somit das Nulleitersignal GND zugeführt. Durch zeitgleiches Umschalten der Multiplexer 11a und 11b der Signalkanäle a bzw. b werden zeitgleich die Spannungs- und Stromsignale U1,I1 oder U2,I2 oder U3,I3 erfaßt und digitalisiert. Die Digitalsignale werden in der Signalverarbeitungseinrichtung 3 weiter verarbeitet. Dabei wird z.B. aus der Summe der Produkte der Spannungs- und Stromsignale gemäß der Beziehung:

$$P = U1 \times I1 + U2 \times I2 + U3 \times I3$$

die Verbraucherleistung bestimmt, die als Ergebnissignal SE über die Schnittstelle 5 dem Zähler 1 entnommen werden kann. Dabei werden von den Modulatoren 15a, 15b gelieferte Bitströme mit einer Abtastrate von 1 bis 2 MHz im Dezimationsfilter 17a bzw. 17b in bitparallele Signale (Bitbreite 18 bis 20) mit einer vergleichsweise niedrigen Abtastrate von 1 bis 2 kHz, jedoch hoher Auflösung umgewandelt.

Beim Betrieb als Dreileiterzähler wird - gesteuert durch die digitale Signalverarbeitungseinrichtung 3 - der Multiplexer 13a des ersten Signalkanals a auf das Spannungssignal U2 geschaltet. In diesem Fall ist der Nulleiter nicht mit dem Nulleitersignal GND gekoppelt, sondern es bildet sich über die den Spannungssignalen U1 bis U3 entsprechenden Signalanschlüße ein künstlicher Sternpunkt aus. Im Modulator 15a wird daher bei abwechselndem Umschalten des Multiplexers 11a zwischen den Spannungssignalen U1 und U3 die jeweilige Differenzspannung U12 bzw. U32 direkt erfaßt. Der entsprechende Digitalwert am Ausgang des Modulators 15a entspricht damit dem Spannungswert U12 = U1 - U2 bzw. U32 = U3 - U2. Durch zeitgleiche Messung der Stromsignale I1 und I3 im zweiten Signalkanal b kann wiederum in der digitalen Signalverarbeitungseinrichtung 3 die Verbrauchsleistung gemäß der Beziehung:

$$P = U12 \times I1 + U32 \times I3$$

ermittelt werden. Damit ist die Aronschaltung ohne unterschiedliche Hardware-Varianten realisiert. In der beim Vierleiterbetrieb durchgeführten Messung eingesetzte Justierfaktoren können auch im Dreileiterbetrieb verwendet werden. Für den Analog/Digital-Wandler oder Modulator 15a bedeutet dies keinen nennenswerten Mehraufwand, da der Sigma-Delta-Wandler ohnehin mit Differenzeingang realisiert ist.

**Patentansprüche**

**1.** Elektrizitätszähler (1) mit auf eine digitale Signalverarbeitungseinrichtung (3) geführten Signalkanälen (a, b), von denen jeder einen Analog/Digital-Wandler (15a, 15b) aufweist, wobei auf einen ersten Eingang ($E_{1a}$) des Analog/Digital-Wandlers (15a) eines ersten Signalkanals (a) mittels Wandlern erfaßte Spannungssignale (U1 bis U3) und auf einen ersten Eingang ($E_{1b}$) des Analog/Digital-Wandlers (15b) des zweiten Signalkanals (b) mittels Wandlern erfaßte Stromsignale (I1 bis I3) eines elektrischen Verbrauchers aufschaltbar sind,
**dadurch gekennzeichnet, daß**
zumindest der Analog/Digital-Wandler (15a) des ersten Signalkanals (a) einen zweiten Eingang ($E_{2a}$) aufweist, wobei der erste und der zweite Eingang ($E_{1a}$ bzw. $E_{2a}$) einen Differenzeingang bilden, und wobei dem zweiten Eingang ($E_{2a}$) ein Umschalter (13a) vorgeschaltet ist, der entweder eines der Spannungssignale (U2) oder ein Nulleitersignal (GND) auf den Zweiten Eingang ($E_{2a}$) führt.

**2.** Elektrizitätszähler nach Anspruch 1,
**dadurch gekennzeichnet, daß** der Umschalter als Multiplexer (13a) ausgeführt ist.

**3.** Elektrizitätszähler nach Anspruch 1 oder 2,
**dadurch gekennzeichnet, daß** dem ersten Eingang ($E_{1a}$, $E_{1b}$) des jeweiligen Analog/Digital-Wandlers (15a, 15b) ein Multiplexer (11a bzw. 11b) vorgeschaltet ist, wobei diese Multiplexer (11a, 11b) eingangsseitig für die Erfassung von dreiphasigen Meßwerten ausgebildet sind.

**4.** Elektrizitätszähler nach Anspruch 3,
**dadurch gekennzeichnet, daß** die Multiplexer (11a, 13a, 11b) miteinander synchronisiert sind.

**5.** Elektrizitätszähler nach einem der Ansprüche 1 bis 4,
**dadurch gekennzeichnet, daß** bei Aufschaltung des Spannungssignals (U2) auf den zweiten Eingang ($E_{2a}$) des Analog/Digital-Wandlers (15a) des ersten Signalkanals (a) dessen erstem Eingang ($E_{1a}$) eines der anderen Spannungssignale (U1, U3) aufgeschaltet ist, wobei der Analog/Digital-Wandler (15a) ausgangsseitig die entsprechende Differenzspannung (U12, U22, U32) liefert.

**6.** Elektrizitätszähler nach einem der Ansprüche 1 bis 5,
**dadurch gekennzeichnet, daß** in jedem der beiden Signalkanäle (a, b) zwischen den Analog/Digital-Wandler (15a, 15b) und die digitale Signalverarbeitungseinrichtung (3) ein Dezimationsfilter (17a bzw. 17b) geschaltet ist.

**7.** Elektrizitätszähler nach einem der Ansprüche 1 bis 6,
**dadurch gekennzeichnet, daß** in den zweiten Signalkanal (b) ein Hochpaß-Filter (19b) geschaltet ist.

8. Elektrizitätszähler nach einem der Ansprüche 1 bis 7,
   **dadurch gekennzeichnet, daß** den Analog/Digital-Wandlern (15a, 15b) und der digitalen Signalverarbeitungseinrichtung (3) eine gemeinsame Systemtaktvorrichtung (7) zugeordnet ist.

9. Elektrizitätszähler nach einem der Ansprüche 1 bis 8,
   **dadurch gekennzeichnet, daß** jeder Analog/Digital-Wandler (15a, 15b) ein Sigma-Delta-Modulator, vorzugsweise zweiter Ordnung, ist.

10. Verfahren zum Betrieben eines Elektrizitätszählers nach einem der Ansprüche 1 bis 9,
    **dadurch gekennzeichnet,**

    - **daß** beim Betrieb als Vierleiterzähler die Summe der Produkte aus den im ersten Signalkanal (a) erfaßten Spannungssignalen (U1 bis U3) und den zeitgleich im zweiten Signalkanal (b) erfaßten Stromsignalen (I1 bis I3) gebildet wird, wobei auf den zweiten Eingang ($E_{2a}$) des Analog/Digital-Wandlers (15a) des ersten Signalkanals (a) ein Nulleitersignal (GND) geschaltet ist, und
    - **daß** beim Betrieb als Dreileiterzähler die Summe der Produkte aus im ersten Signalkanal (a) erfaßten Differenzspannungen (U12, U32) und den zeitgleich im zweiten Signalkanal (b) erfaßten Stromsignalen (I1, I3) gebildet wird, wobei auf den zweiten Eingang ($E_{2a}$) des Analog/Digital-Wandlers (15a) des ersten Signalkanals (a) eines der Spannungssignale (U2) geschaltet ist.

**Claims**

1. Electricity meter (1) with signal channels (a, b) routed to a digital signal processing device (3), each channel having an analog/digital converter (15a, 15b), voltage signals (U1 to U3) of an electrical consumer, which are detectable by means of transformers, being connectable to a first input ($E_{1a}$) of the analog/digital converter (15a) of a first signal channel (a) and current signals (I1 to I3) of an electrical consumer, which are detectable by means of transformers, being connectable to a first input ($E_{1b}$) of the analog/digital converter (15b) of the second signal channel (b), **characterized in that** at least the analog/digital converter (15a) of the first signal channel (a) has a second input ($E_{2a}$), the first and the second input ($E_{1a}$ and $E_{2a}$ respectively) forming a difference input, and a changeover switch (13a) being connected upstream of the second input ($E_{2a}$), which switch routes either one of the voltage signals (U2) or a neutral conductor signal (GND) to the second input ($E_{2a}$).

2. Electricity meter according to claim 1, **characterized in that** the changeover switch is executed as a multiplexer (13a).

3. Electricity meter according to claim 1 or 2, **characterized in that** a multiplexer (11a or 11b respectively) is connected upstream of the first input ($E_{1a}$, $E_{1b}$) of the respective analog/digital converter (15a, 15b), these multiplexers (11a, 11b) being formed on the input side to detect three-phase measured values.

4. Electricity meter according to claim 3, **characterized in that** the multiplexers (11a, 13a, 11b) are synchronized with one another.

5. Electricity meter according to one of claims 1 to 4, **characterized in that** when the voltage signal (U2) is connected to the second input ($E_{2a}$) of the analog/digital converter (15a) of the first signal channel (a), one of the other voltage signals (U1, U3) is connected to its first input ($E_{1a}$), the analog/digital converter (15a) supplying the appropriate difference voltage (U12, U22, U32) on its output side.

6. Electricity meter according to one of claims 1 to 5, **characterized in that** a decimation filter (17a or 17b) is connected between the analog/digital converter (15a, 15b) and the digital signal processing device (3) in each of the two signal channels (a, b).

7. Electricity meter according to one of claims 1 to 6, **characterized in that** a high-pass filter (19b) is connected in the second signal channel (b).

8. Electricity meter according to one of claims 1 to 7, **characterized in that** assigned to the analog/digital converters (15a, 15b) and the digital signal processing device (3) is a common system clock device (7).

9. Electricity meter according to one of claims 1 to 8, **characterized in that** each analog/digital converter (15a, 15b) is a sigma-delta modulator, preferably of the second order.

10. Method for operating an electricity meter according to one of claims 1 to 9, **characterized in that**

    - when operated as a four-conductor meter, the sum of the products is formed from the voltage signals (U1 to U3) detected in the first signal channel (a) and the current signals (I1 to I3) detected simultaneously in the second signal channel (b), a neutral conductor signal (GND) being switched to the second input ($E_{2a}$) of the analog/digital converter (15a) of the first signal channel (a), and

- when operated as a three-conductor meter, the sum of the products is formed from the difference voltages (U12, U32) detected in the first signal channel (a) and the current signals (I1, I3) detected simultaneously in the second signal channel (b), one of the voltage signals (U2) being switched to the second input ($E_{2a}$) of the analog/digital converter (15a) of the first signal channel (a).

## Revendications

1. Compteur électrique (1) comportant des canaux de signaux (a, b) qui sont dirigés vers un dispositif de traitement de signal numérique (3) et qui ont chacun un convertisseur analogique-numérique (15a, 15b), des signaux de tension (U1 à U3), détectés au moyen de transformateurs, d'un consommateur électrique pouvant être appliqués à une première entrée ($E_{1a}$) du convertisseur analogique-numérique (15a) d'un premier canal de signal (a) et des signaux de courant (11 à 13), détectés au moyen de transformateurs, du consommateur électrique pouvant être appliqués à une première entrée ($E_{1b}$) du convertisseur analogique-numérique (15b) du deuxième canal de signal (b),

   **caractérisé par le fait qu'**au moins le convertisseur analogique-numérique (15a) du premier canal de signal (a) comporte une deuxième entrée ($E_{2a}$), la première et la deuxième entrée ($E_{1a}$ respectivement $E_{2a}$) formant une entrée différentielle, et

   un commutateur (13a) étant branché du côté amont de la deuxième entrée ($E_{2a}$), lequel commutateur envoie à la deuxième entrée ($E_{2a}$) soit l'un des signaux de tension (U2) soit un signal de fil neutre (GND).

2. Compteur électrique selon la revendication 1,
   **caractérisé par le fait que** le commutateur est conçu comme un multiplexeur (13a).

3. Compteur électrique selon la revendication 1 ou 2,
   **caractérisé par le fait qu'**un multiplexeur (11a respectivement 11b) est branché du côté amont de la première entrée ($E_{1a}$, $E_{1b}$) du convertisseur analogique-numérique respectif (15a, 15b), ces multiplexeurs (11a, 11b) étant conçus côté entrée pour la détection de valeurs mesurées triphasées.

4. Compteur électrique selon la revendication 3,

   **caractérisé par le fait que** les multiplexeurs (11a, 13a, 11b) sont synchronisés entre eux.

5. Compteur électrique selon l'une des revendications 1 à 4,
   **caractérisé par le fait que**, lors du branchement du signal de tension (U2) sur la deuxième entrée ($E_{2a}$) du convertisseur analogique-numérique (15a) du premier canal de signal (a), la première entrée ($E_{1a}$) de ce convertisseur analogique-numérique (15a) reçoit l'un des autres signaux de tension (U1, U3), le convertisseur analogique-numérique (15a) fournissant en sortie la tension différentielle correspondante (U12, U22, U32).

6. Compteur électrique selon l'une des revendications 1 à 5,
   **caractérisé par le fait que**, dans chacun des deux canaux de signaux (a, b), un filtre de décimation (17a respectivement 17b) est branché entre le convertisseur analogique-numérique (15a, 15b) et le dispositif de traitement de signal numérique (3).

7. Compteur électrique selon l'une des revendications 1 à 6,
   **caractérisé par le fait qu'**un filtre passe-haut (19b) est branché dans le deuxième canal de signal (b).

8. Compteur électrique selon l'une des revendications 1 à 7,
   **caractérisé par le fait qu'**un dispositif d'horloge de système (7) commun est associé aux convertisseurs analogiques-numériques (15a, 15b) et au dispositif de traitement de signal numérique (3).

9. Compteur électrique selon l'une des revendications 1 à 8,
   **caractérisé par le fait que** chaque convertisseur analogique-numérique (15a, 15b) est un modulateur delta-sigma, de préférence de deuxième ordre.

10. Procédé pour faire fonctionner un compteur électrique selon l'une des revendications 1 à 9,
    **caractérisé par le fait que**

    - lors du fonctionnement comme compteur à quatre fils, on forme la somme des produits des signaux de tension (U1 à U3) détectés dans le premier canal de signal (a) et des signaux de courant (I1 à I3) détectés simultanément dans le deuxième canal de signal (b), un signal de fil neutre (GND) étant branché sur la deuxième entrée ($E_{2a}$) du convertisseur analogique-numérique (15a) du premier canal de signal (a), et
    - lors du fonctionnement comme compteur à trois fils, on forme la somme des produits de tensions différentielles (U12, U32) détectées dans le premier canal de signal (a) et des signaux de courant (11, 13) détectés simultanément dans le deuxième canal de signal (b), l'un des signaux de tension (U2) étant branché sur la deuxième entrée ($E_{2a}$) du convertisseur analogique-numérique (15a) du premier canal de signal (a).